Europäisches Patentamt

European Patent Office

Office européen des brevets

(11) Publication number: 0 298 126 B1

# EUROPEAN PATENT SPECIFICATION

(45) Date of publication of patent specification: 15.06.94  (51) Int. Cl.⁵: C23C 16/48

(21) Application number: 88900591.4

(22) Date of filing: 25.12.87

(86) International application number:
PCT/JP87/01040

(87) International publication number:
WO 88/05087 (14.07.88 88/15)

(54) OPTICAL CVD PROCESS.

(30) Priority: 25.12.86 JP 308049/86
12.08.87 JP 199984/87
12.08.87 JP 199985/87

(43) Date of publication of application:
11.01.89 Bulletin 89/02

(45) Publication of the grant of the patent:
15.06.94 Bulletin 94/24

(84) Designated Contracting States:
DE FR GB

(56) References cited:
EP-A- 0 204 538      FR-A- 2 548 218
JP-A- 44 183         JP-A- 91 010
JP-A- 132 593        JP-A- 220 139
JP-A- 30 028         US-A- 4 759 947

(73) Proprietor: KAWASAKI STEEL CORPORATION
No. 1-28, 1-Chome Kitahonmachi-Dori
Chuo-Ku, Kobe-City Hyogo 651(JP)

(72) Inventor: OHTA, Tomohiro
Kawasaki Steel Corporation Technical Re-
search Div
1, Kawasaki-cho Chiba-shi Chiba 260(JP)
Inventor: SASAKI, Hiroaki
Kawasaki Steel Corporation Technical Re-
search Div
1, Kawasaki-cho Chiba-shi Chiba 260(JP)
Inventor: MITOMO, Tohru
Kawasaki Steel Corporation Technical Re-
search Div
1, Kawasaki-cho Chiba-shi Chiba 260(JP)
Inventor: KUBOTA, Naoki
Kawasaki Steel Corporation Technical Re-
search Div
1, Kawasaki-cho Chiba-shi chiba 260(JP)

(74) Representative: Patentanwälte Grünecker,
Kinkeldey, Stockmair & Partner
Maximilianstrasse 58
D-80538 München (DE)

EP 0 298 126 B1

## Description

Technical Field

This invention relates to a photochemical vapor deposition process by using plural pulse laser beams (hereinafter referred to as photo CVD process) for forming a film through a photolytical reaction.

Background Art

The photo CVD process is a main means for the formation of thin film among low temperature processes and restrains the interdiffusion at the surface without damaging the substrate, so that it is applied to the formation of amorphous silicon films for solar cell (hereinafter referred to as a-Si film), or diamond-like carbon thin films and carbon films having a diamond structure (hereinafter referred to as diamond film) expected as a high functional material having simultaneously high hardness, high thermal conductivity, high insulation property and the like, or thin films of silicon carbide, silicon nitride and silicon dioxide used or applicable for semiconductor devices.

Since such thin films play a main important part in the modern industry, film formation processes represented by PVD process (Physical Vapor Deposition process) and CVD process (Chemical Vapor Deposition process) have been recently developed and applied and practised in various fields.

Among them, photo CVD process wherein a source gas is existent in the vicinity of a substrate and is subjected to photolysis and then the resulting active chemical species are deposited onto the substrate is important as one of low temperature processes causing no damage of the substrate and inducing no unnecessary interdiffusion at the surface.

As a light source for the photo CVD process, there are generally two kinds of continuous light and discontinuous light (pulse beam).

The former case includes a low pressure mercury lamp, a high pressure mercury lamp, a deuterium lamp, a xenon lamp, an Ar ion laser and the like. These continuous light sources have a drawback that the deposition rate is very slow because a light of absorption range which induces excitation causing photolytic process inherent to the source gas is not emitted, or if a light of a wavelength existing in this absorption range is emitted, a power thereof is weak.

The photo CVD process has a merit capable of forming films in a low temperature process, which is never achieved in the other film forming processes, but there are problems to be solved, such as small deposition rate and poor film quality in the photo CVD process using the continuous light. Therefore, there have been proposed various methods for solving these problems.

The proposed techniques are as follows.

(1) Method wherein laser beams are focused and irradiated to a reactive gas from two or more different directions to expect local multiphoton dissociation process (Japanese Patent laid open No. 61-96,725).

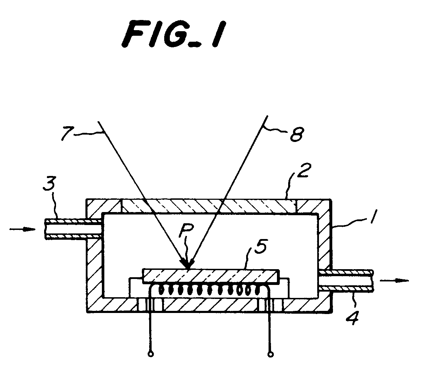

As shown in Fig. 1, this method is performed by placing a substrate 5 in a reaction chamber 1 provided with a light irradiation window 2, introducing a gas from an inlet 3 and irradiating two laser beams 7, 8 from different directions to a point P on the substrate.

(2) Method of synthesizing a thin film by simultaneously introducing plural source gases into a CVD reaction chamber and simultaneously irradiating lights of plural wavelengths matched with the absorption spectrum of each gas (Japanese Patent laid open No. 60-206,445).

(3) Method wherein lights of two different wavelengths are simultaneously irradiated into a CVD reaction chamber to cause decomposition of a source gas through a light of a first wavelength and successively decompose the resulting decomposed products through a light of a second wavelength (Japanese Patent laid open No. 62-7,122).

(4) Method wherein a laser beam is irradiated in parallel to a substrate surface to cause photolysis of a source gas and another laser beam is irradiated to the substrate to heat the substrate for increasing the deposition rate (Japanese Patent laid open No. 61-30,028) or cause excitation of the substrate for increasing the deposition rate (Japanese Patent laid open No. 61-108,130).

In these methods using the continuous light, the deposition rate is small only with the single continuous light, so that it is intended to improve the deposition rate by adding another continuous light. However, the energy of the continuous light is generally low, so that the expected effect is not obtained by using only the continuous light source.

On the other hand, in the method using a strong discontinuous light source represented by an excimer laser or the like having a high energy, a slightly large deposition rate can be realized when using a source gas having a large absorption cross section, but it is difficult to form a thin film having a good film quality because powder is undesirably produced.

The most serious drawback of the excimer laser is that it is a pulse light source, so that there are disadvantages that the half-width of pulse is not more than 20 ns and the pulse repeating number is restricted. That is, the effective time causing the photolytic reaction actually contributing to the formation of films is very short in a time required for the film formation. For example, when a duration time of one pulse beam is 20 ns, even if the beam is irradiated at 100 Hz for 1 hour, the beam irradiated time is only $7.2 \times 10^{-3}$ second ($20 \times 10^{-9} \times 100 \times 60 \times 60 = 7.2 \times 10^{-3}$). Since the beam of high energy is irradiated for a very short time, the degradation of the film quality inclusive of production of powder is brought about. On the other hand, when using a source material of poor photochemical reactivity for controlling the production of powder, the deposition rate lowers and at the same time a greater part of the source gas is discharged as an unreacted state.

Under the same irradiation conditions, the irradiation time of not more than 20 ns and the non-irradiation time longer by 1,000,000 times than the irradiation time, i.e. 10 ms are repeated, so that the concentration of radicals produced largely changes between a pulse and the next pulse and consequently the main elementary reaction is different depending on the time and the reaction becomes at a non-steady state. That is, the preferable reaction for the film formation proceeds for a certain time, while particles are formed for another certain time to mainly cause the reaction degrading the film quality, whereby the degradation of the film quality is caused in the CVD process using the pulse laser beam.

In addition to problems relating to the light irradiating process as mentioned above, the conventional photo CVD processes have problems as mentioned below. For instance, if it is intended to produce a-Si film, diamond film or the like by using the conventional photo CVD process based on direct photolysis of the source gas, it is necessary to provide a light source of a wavelength capable of being absorbed by the particular source gas or to prepare a source gas capable of being subjected to a photolysis by the particular light source.

However, even if the light source suitable for the particular source gas is existent, since the decomposition quantum efficiency of the source gas decomposed by this light source is inherent to this gas, it is impossible to promote the film forming reaction exceeding the above quantum efficiency. This is a drawback in the conventional photo CVD process.

For example, if it is intended to produce a-Si film, since $SiH_4$ having an absorption end of 170 nm is not decomposed by the commercially available lamp light, it is obliged to decompose an expensive source gas of $Si_2H_6$ having a shifted absorption end of 200 nm by a light of an excimer laser having a wavelength of 193 nm, resulting in the rise of cost and the degradation of the film quality.

Moreover, the film formation can be also carried out by a combination of a mercury lamp and $SiH_4$, but in this case, it is necessary to adopt a so-called mercury sensitization process wherein Hg vapor is mixed with the source gas.

That is, Hg atom is excited by a light from the mercury lamp and collides with $SiH_4$ molecule to cause energy transfer from Hg atom, whereby Si-H bonds in $SiH_4$ are cut to form a-Si film onto the substrate. In the mercury sensitization process, however, Hg atom is included in the film, resulting in a large cause of degrading the film quality of the a-Si film.

On the other hand, if it is intended to produce diamond film, when using $CH_4$ (absorption end 160 nm) as a source gas, it is not decomposed even if a practicable light source having a shortest wavelength of 193 nm is used alone, but it is first possible to form a film by using, for example, $F_2$ excimer laser beam of vacuum ultraviolet region (wavelength 157 nm). However, the pulse energy of the laser beam having a wavelength of 157 nm is as small as about 10 mJ/pulse and is about 1/10~1/20 as compared with the case of a light having the other wavelength, and also this wavelength is large in the absorption by air and difficult in handling, so that it is unpratical.

Furthermore, when a source gas having a weak or no one-photon absorption process is used to perform the film formation at a practical wavelength of 193 nm, as disclosed in Japanese Patent laid open No. 60-112,697, the decomposition should be carried out by two-photon absorption at a region having an energy density raised by focusing of the beam, so that the film forming area is restricted and the deposition rate becomes small.

Similarly, Japanese Patent laid open No. 60-146,791 has proposed the use of a gas such as acetylene, ethylene or the like as a source gas decomposed at the wavelength of 193 nm, but the use of such gas is unpractical because the deposition rate is restricted.

As mentioned above, the photo CVD process has a merit that it is a low temperature process and a demerit that the deposition rate inherent to photo CVD is small, so that the excimer laser beam having a strong light emission in the ultraviolet region is frequently used in order to overcome this demerit. However, the excimer laser beam is emitted in a series of pulses because of restricting the oscillation mechanism and electric circuits, while there is a limitation in raising its frequency.

Therefore, there are two great disadvantages in the photo CVD process using the pulse laser beam as a light source, which results from the above restriction.

That is, the first case is that the effective time of light irradiation is small and hence the waste of the source gas is large. The second case is that the reaction is rendered into a non-steady state to cause a so-called "disturbance of reaction" and hence the film quality is degraded.

It is an object of the invention to avoid the reduction of decomposition rate of the source gas resulted from an extremely short irradiation time in the film formation through the photo CVD process using a pulse ultraviolet laser of a large power and hence improve the small deposition rate.

It is another object of the invention to increase the deposition rate to thereby improve the film quality by taking a means for minimizing the "disturbance of reaction" resulted from the extreme change of radical concentrations between a pulse and the next pulse.

Here, it is important to attempt the improvement of the film quality by stably and continually conducting photochemical reaction in the vapor phase near to the substrate or on the substrate itself or in the film layer formed on the substrate even in a non-irradiated time between a pulse and the next pulse.

On the other hand, the most fundamental problem in the photo CVD process lies in that the source gas suitable for the film formation is not necessarily adaptable to the practical light source.

That is, the preferable source gas is not necessarily decomposed by absorbing a light from the practical light source, or inversely, there is existent no effective source gas suitable for excitation and decomposition by the light source.

Moreover, even when the proper source gas is decomposed by the practical light source, if the absorption cross section of the source gas for the wavelength is small, photons are hardly absorbed by gas molecules, so that it is disadvantageous for economical reasons. Further, in the process of excitation and decomposition of particular source gas, there is an upper limit of quantum efficiency of decomposition resulted from the combination of elementary reactions, so that the yield exceeding the upper limit is not expected and further developing the efficiency of the process is impossible.

That is, all of the conventional photo CVD processes perform the decomposition of the source gas itself by the light itself, so that they have a problem that the source gas, light source and film forming area are subjected to a great restriction in practical use.

Now, the other object of the invention is to provide a photo CVD process enabling the use of inexpensive source gas which realizes the application of a light source irrespective of the wavelength value of light absorption end of the source gas and the improvement of the film quality and deposition rate.

Disclosure of the Invention

As mentioned above, in order to overcome the drawback that the deposition rate inherent to the photo CVD process is small, the excimer laser beam having a strong light emission at the ultraviolet region was used, but the excimer laser beam was emitted in a series of pulses because of restricting the oscillation mechanism and electric circuits for the excimer laser and also the frequency thereof was restricted.

On the other hand, in case of the continuous light, the deposition rate is small, but the good film quality is obtained. For example, when $SiH_4$ is subjected to photolysis through a low pressure mercury lamp, a-Si film having a good film quality is obtained.

Among these differences therebetween, the difference of the deposition rate results from a fact that in the pulse laser beam, a light having a great energy can locally be irradiated to a restricted portion to thereby raise the decomposition rate of the source gas, while it is difficult in the mercury lamp or the like.

Furthermore, the difference of the film quality results from a fact that in the mercury lamp or the like, the reaction inside the CVD reaction chamber becomes at a steady state because of the irradiating the continuous light and is not dependent upon the time as far as parameters in CVD are not changed, while the disturbance of reaction occurs one each pulse irradiation in the pulse beam.

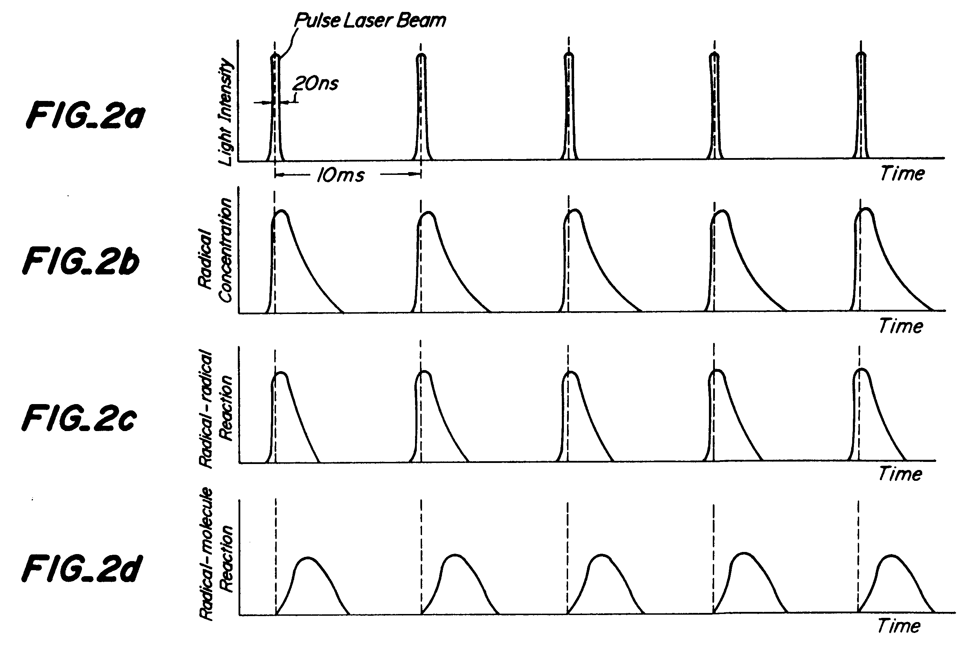

The disturbance of reaction generated when using the pulse laser beam will be described with reference to Fig. 2 below.

Fig. 2(a) schematically shows a change of light intensity with the lapse of time when irradiating a typical excimer laser beam of 100 Hz as a photo CVD process using a pulse laser beam. In general, the pulse width is not more than 20 ns and the pulse interval is 10 ms, so that the light irradiation is merely performed in a time corresponding to only about a millionth of the pulse interval. Calculating under this condition, even when one hour is taken for the film formation, the effective time for the light irradiation is $7 \times 10^{-3}$ second and is less than 1 second as a whole.

4

During this irradiation, the source gas is flown at a given rate, so that the amount of the source gas effectively utilized is very low likewise the above effective light irradiation time. Furthermore, the concentration of radicals produced as a result of the photochemical reaction induced by the short pulse beam can be schematically depicted in Fig. 2(b) as plotted to the time.

Namely, the dissociation reaction of chemical bond through absorption of light occurs immediately after the light absorption, so that the concentration of radicals primarily produced becomes maximum from a last half of the pulse irradiation to just after the irradiation and gradually reduces and finally the period existing no radical is present in about 1/10 of a period between pulses because the life of the radicals under the conventional CVD condition is not more than few ms.

Noting the reactions generated in the vapor phase, radical-radical reaction mainly occurs in a portion having a high radical concentration as shown in Fig. 2(c), so that stable vapor compounds are produced by the recombination reaction or another radical species are secondarily produced by the rearrangement reaction. As the radical concentration at the light irradiation region reduces, radical-molecule reaction mainly occurs together with transfer and diffusion of the source gas as shown in Fig. 2(d). The reaction contributing to the film formation proceeds in competition with the above two reactions, so that such a film forming reaction is not constant between a pulse and the next pulse, resulting in the ununiformity of the film quality.

That is, the degradation of the film quality through the photo CVD process using the pulse beam results from that since the time for the photolytical reaction is very short and the time for the dark reaction is longer by 1,000,000 times as compared therewith, the concentration and kind of radicals produced in the CVD reaction chamber are different and the ratio of each elementary reaction to the overall reaction differs in accordance with the time after the pulse irradiation and consequently the film formation is carried out at a so-called non-steady state.

Therefore, the aforementioned drawbacks can be overcome by continuing the photochemical reaction during the time between a pulse and the next pulse.

In general, the output of the excimer laser beam is about 10~30 watts every single wavelength, while the high pressure mercury lamp of 1 kilowatt has an output of about 10 watts at a wavelength range of 240~600 nm. Therefore, when a proper source gas is selected, the photochemical reaction can continuously be produced even excepting the restricted time of irradiating the pulse laser beam.

The invention is based on the above knowledges.

The term "source gas" used herein means a gas containing a component for the film to be formed, and the term "active chemical species of the vapor phase" means an activated chemical species such as radicals, ions or the like.

Now, the effective time of light irradiation in the film formation is very short under typical conditions for performing the photo CVD process using the pulse laser beam such as excimer laser beam or the like. The improvement of this point can be realized by simultaneously irradiating plural pulse laser beams among which the phase of the second pulse row and thereafter is delayed to that of first pulse row or which have different frequencies. Furthermore, the improvement of the film quality can be realized by irradiating plural pulse laser beams having mutually shifted irradiation times.

That is, as defined in claim 1, the invention is characterized in that in the photo CVD process using plural pulse laser beams, a source gas is introduced into a CVD reaction chamber placing a substrate therein and a pulse row of a first laser beam and at least one pulse row of a second laser beam and thereafter having a different phase to the first pulse row are simultaneously irradiated thereto to improve the deposition rate and film quality.

Furthermore, the invention is a method capable of increasing the deposition rate to obtain the good film quality while holding the merits of the photo CBD process. That is, it is intended that another plural pulse laser beams are irradiated to the source gas on the substrate or to the substrate in a time of long light non-irradiation between a pulse and the next pulse in the first pulse row.

The following three functions are produced in accordance with the manner of the second pulse row to the first pulse row.

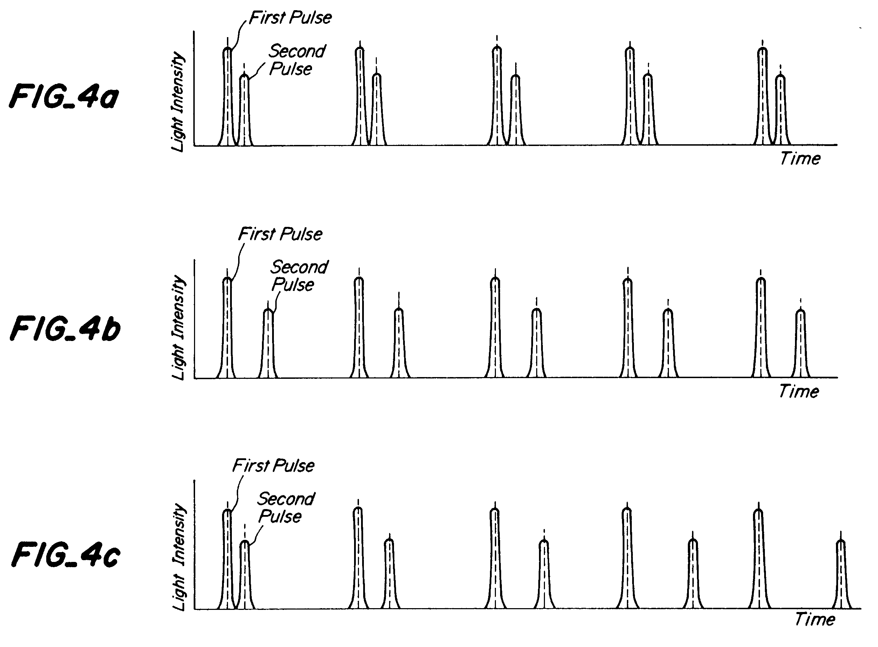

(1) As shown in Fig. 4(a), the delayed pulse lights of the second and thereafter are irradiated during the proceeding of the successive reactions of radicals in the vapor phase produced by the first pulse just after the irradiation of the first pulse, whereby the successive reactions forming powder inconvenient for the formation of film can be suppressed. Further, the reactions effective for the film formation can be accelerated to improve the film quality. The wavelength of the second pulse laser beam and thereafter is not necessarily the same as the wavelength of the first pulse beam and is selected from wavelengths decomposing an unfavorable product for the film formation by-produced in the successive reactions or being absorbed by the film layer formed on the substrate. The delaying time is set to a time during the successive reactions after the completion of the first pulse irradiation, i.e. from 20 ns to 1 ms.

(2) As shown in Fig. 4(b), when the second pulse laser beam and thereafter are irradiated in a time until a new source gas is transferred and diffused after the source gas is decomposed and consumed by the first pulse laser beam at a region of generating the photolytical reaction near to the substrate, the film formation through the second pulse beam and thereafter contributes to the whole deposition rate, whereby the deposition rate is increased as compared with the case of using the first pulse laser alone. In this case, the wavelength of the second laser beam and thereafter is not necessarily the same as that of the first laser beam. However, it is necessary that the source gas is decomposed in the wavelength of them.

(3) Although the frequency of the second pulse beam and thereafter is the same as the frequency of the first laser beam in the above items (1) and (2), the frequencies of plural pulse laser beams are not intentionally matched in this item (see Fig. 4(c)). For example, when using pulse laser beams of 100 Hz and 80 Hz, the phenomenon as a combination of the above items (1) and (2) appears and improvement of the deposition rate and film quality is observed.

Moreover, the third invention is characterized in that plural second pulse rows are irradiated as a pulse having a phase different from that of the first pulse row and does not particularly intend to limit the irradiation directions of all laser beams. In other words, it is not required to irradiate the laser beam only to the source gas or to the substrate or the film layer on the substrate.

Brief Description of Drawings

Fig. 1 is a sectional view illustrating the conventional photo CVD process through irradiation of plural laser beams;

Fig. 2 is a graph showing a reaction analysis of pulse laser CVD;

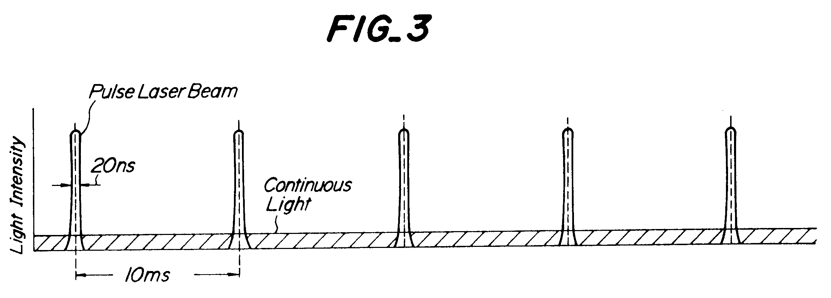

Fig. 3 is a graph illustrating a photo CVD process through irradiation of plural pulse laser beams and continuous light according to the invention;

Fig. 4 is a graph illustrating a photo CVD process through irradiation of plural pulse rows having different phases according to the invention.

Best Mode of Carrying out the Invention

Example

The film formation of $Al_2O_3$ was carried out by using $Al(CH_3)_3$ and $N_2O$ as a source gas.

Using an ArF laser beam (wavelength 193 nm) and a KrF laser beam (wavelength 248 nm) or another ArF laser beam, photo CVD was carried out, wherein the delaying time between two pulse laser beams was 5 ms or 100 $\mu$s, while each laser beam alone was taken as a comparative example.

The impurity, specific resistance and pinhole density of the resulting film were measured to obtain the results as shown in Table 1.

Moreover, the CVD conditions were as follows. frequency of pulse laser beam 100 Hz

| irradiation direction | irradiation in parallel to substrate surface at 1 mm above substrate |
|---|---|
| $Al(CH_3)_3$ | 100 sccm |
| $N_2O$ | 800 sccm |
| He | 100 sccm (purging of entrance window) |
| total pressure | 133.3 Pa (1 torr) |
| substrate | polycrystalline silicon |
| substrate temperature | 300 °C |
| deposition time | 1 hour |

As shown in the results of Table 1, it is obvious that the deposition rate and film quality are improved by the irradiation of plural pulse delayed laser beams proposed in the invention.

## Table 1

| Irradiated wavelength (mm) | Comparative Example | | Example | | | |
|---|---|---|---|---|---|---|
| | 193 | 248 | 193+193 | 193+193 | 193+248 | 193+248 |
| Delaying time | – | – | 5 ms | 100 μs | 5 ms | 100 μs |
| Deposition rate (μm/h) | 6.2 | 2.4 | 15.0 | 9.5 | 9.8 | 8.9 |
| Impurity (carbon) % | 1.2 | 3.2 | 0.9 | 0.6 | 1.0 | 0.5 |
| Specific resistance (Ωcm) | $10^{11}$ | $10^{10}$ | $10^{12}$ | $10^{13}$ | $10^{12}$ | $10^{13}$ |
| Pinhole density (/cm$^2$) | 2 | 7 | <1 | <1 | <1 | <1 |

Industrial Applicability

According to the invention, the increase of deposition rate and the considerable improvement of film quality are attempted by simultaneously irradiating a first pulse laser beam and a second delayed pulse laser beam. Moreover, the decomposition ratio of the source gas can be increased to efficiently utilize the expensive source gas, so that there is an effect of reducing the cost.

As mentioned above, according to the invention, semiconductor films and the like having higher quality and accuracy can efficiently be manufactured, so that the industrial contribution is large.

## Claims

1. A photochemical vapor deposition process by using plural pulse laser beams, comprising introducing a source gas containing a component of a film to be formed on a substrate into a reaction vessel, placing the substrate into the reaction vessel, irradiating the source gas with pulses of a first laser beam and pulses of at least one other laser beam, each of the pulses of the at least one other laser beam having a different phase to each of the pulses of the first laser beam.

2. The photochemical vapor deposition process according to claim 1, wherein the plural pulse laser beams have the same pulse interval and the delaying time of a pulse of the at least one other laser beam from the corresponding pulse of the first laser beam is from 20 ns to 1 ms in which the successive reactions of radicals in the vapor phase produced by the irradiation of the pulse of the first laser beam proceeds.

## Patentansprüche

1. Photochemisches Dampfabscheidungsverfahren unter Verwendung vieler gepulster Laserstrahlen, umfassend das Einführen eines Quellengases, welches eine Komponente einer Schicht enthält, welche auf einem Substrat in einem Reaktionsbehälter gebildet werden soll, das Plazieren des Substrats in dem Reaktionsbehälter, das Bestrahlen des Quellengases mit Pulsen eines ersten Laserstrahls und Pulsen wenigstens eines anderen Laserstrahls, wobei jeder der Pulse des wenigstens einen anderen Laserstrahls eine andere Phase aufweisen als jeder der Pulse des ersten Laserstrahls.

2. Photochemisches Dampfabscheidungsverfahren nach Anspruch 1, wobei die vielen gepulsten Laserstrahlen die gleichen Pulsintervalle aufweisen und wobei die Verzögerungszeit eines Pulses des wenigstens eines anderen Laserstrahls von dem entsprechenden Puls des ersten Laserstrahls aus zwischen 20 ns und 1 ms liegt, in denen die nachfolgenden Reaktionen der Radikale in der Dampfphase, erzeugt durch die Bestrahlung der Pulse des ersten Laserstrahles, fortschreitet.

**Revendications**

1. Procédé de métallisation photochimique sous vide à l'aide de plusieurs faisceaux laser pulsés, consistant à introduire dans un réacteur un gaz source contenant un composant d'un film destiné à être formé sur un substrat, à placer le substrat dans le réacteur, à irradier le gaz source par des impulsions d'un premier faisceau laser eu des impulsions d'au moins un autre faisceau laser, chacune des impulsions de l'au moins autre faisceau laser ayant une phase différente de chacune des impulsions du premier faisceau laser.

2. Procédé de métallisation photochimique sous vide selon la revendication 1, dans lequel plusieurs faisceaux laser pulsés ont le même intervalle entre impulsions, et le retard entre une impulsion de l'au moins un autre faisceau laser et l'impulsion correspondante du premier faisceau laser est de 20 ns à 1 ms, laps de temps pendant lequel ont lieu les réactions successives des radicaux dans la phase vapeur produits par irradiation due à l'impulsion du premier faisceau laser.

# FIG. 1

EP 0 298 126 B1

**FIG.2a**

Pulse Laser Beam

20ns

10ms

Light Intensity

Time

**FIG.2b**

Radical Concentration

Time

**FIG.2c**

Radical-radical Reaction

Time

**FIG.2d**

Radical-molecule Reaction

Time

# FIG. 3

Light Intensity

Pulse Laser Beam

20ns

Continuous Light

10ms

EP 0 298 126 B1

EP 0 298 126 B1

FIG_4a

FIG_4b

FIG_4c

First Pulse
Second Pulse
Light Intensity
Time

12